# EUROPÄISCHE PATENTSCHRIFT

(11) **EP 2 545 594 B1**
(45) Veröffentlichungstag und Bekanntmachung des Hinweises auf die Patenterteilung: **16.11.2016**
(21) Anmeldenummer: 11707123.3
(22) Anmeldetag: 21.02.2011
(51) Int. Cl.: H01L 31/18, H02S 50/10, H01L 21/67

(54) **PRÜFEINRICHTUNG UND EIN PRÜFVERFAHREN**
TEST DEVICE AND A TEST METHOD
DISPOSITIF DE CONTRÔLE ET PROCÉDÉ DE CONTRÔLE

(30) Priorität: 12.03.2010 DE 202010000365 U
(43) Veröffentlichungstag der Anmeldung: 16.01.2013
(73) Patentinhaber: KUKA Industries GmbH, 86165 Augsburg (DE)
(72) Erfinder: BECK, Dietmar, 86316 Friedberg (DE); SCHMIDT, Dieter, 86438 Kissing (DE)
(74) Vertreter: Ernicke, Klaus Stefan
(86) Internationale Anmeldenummer: PCT/EP2011/052540
(87) Internationale Veröffentlichungsnummer: WO 2011/110419

(56) Entgegenhaltungen:
- EP-A1- 1 647 827
- EP-A1- 1 956 366
- DE-A1- 10 146 879
- DE-A1-102007 042 521
- JP-A- 2001 091 567
- US-A- 5 334 844
- US-A1- 2005 252 545
- US-A1- 2009 020 392

## Beschreibung

Die Erfindung betrifft eine Prüfeinrichtung und ein Prüfverfahren für ein Werkstück, insbesondere ein Solarmodul mit einer Solarzellenanordnungen.

Bei der Herstellung von Solarmodulen bzw. Photovoltaikelementen wird ein mehrlagiges Sandwich unter Einbettung einer Solarzellenanordnung gebildet, die z.B. als gleichmäßige Zellenmatrix vorliegt und aus mehreren Strings einzelner untereinander durch elektrische Leitungen bzw. Bändchen verbundenen Solarzellen besteht. Das Sandwich besteht aus einer lichtdurchlässigen Grundplatte, z.B. einer Glasplatte, der vorgenannten Lage der Solarzellenanordnung und einer üblicherweise weitgehend lichtundurchlässigen Decklage. Dazwischen können ein oder mehrere weitere Lagen aus Einbettungsfolien oder dgl. liegen. Das Sandwich hat zunächst eine lose Lagenschichtung und wird anschließend in einem sog. Laminator verbacken und zu einer Einheit fest verbunden. Wenn Modulteile, insbesondere die Solarzellenanordnung, fehlerhaft sind, kann nach dem Laminieren nicht mehr nachgebessert werden, was zu Ausschuss und einem hohen Wertverlust führt. Beim Assembling des Solarmoduls und bei der Stringherstellung können zwar die Solarzellen und der String geprüft werden. Beim anschließenden Assembling und beim Transport des losen Sandwiches können weitere Fehlereinflüsse bestehen.

Dokument DE 102007042521 A1 beschreibt ein Verfahren zur Durchstrahlung dünner Medien und der Aufzeichnung der Durchdringung der Medien mittels elektronischer Sensoren. Dokument EP 1956366 A1 beschreibt ein Verfahren und eine Vorrichtung zur Detektierung von Defekten in dünnen Wafer-Platten.

Es ist daher Aufgabe der vorliegenden Erfindung, eine Prüfungsmöglichkeit für ein Solarmodul oder ein anderes Werkstück aufzuzeigen, insbesondere wenn dieses einen mehrlagigen losen Lagenaufbau hat.

Die Erfindung löst diese Aufgabe mit den Merkmalen in den unabhängigen Ansprüchen 1 und 11.

Die Prüftechnik, d.h. die Prüfeinrichtung und das Prüfverfahren, ermöglichen eine Prüfung des Solarmoduls und ggf. seiner Bestandteile, insbesondere der Solarzellenanordnung, vor dem Verbinden und Fixieren seiner Lagen. Etwaige Fehler können noch in einer nachgeschalteten Nachbearbeitung oder auf andere Weise behoben werden. Hierdurch lässt sich teurer Ausschuss vermeiden. Etwaige Fehlereinflüsse beim Assembling des mehrlagigen Werkstücks bzw. Solarmoduls und dessen weiterer Handhabung können erfasst und ggf. eliminiert werden. Die Vorteile gelten auch für andere Arten von Werkstücken.

Die Prüftechnik erhöht signifikant die Wirtschaftlichkeit der Solarmodulfertigung. Die Solarzellen und auch die Strings bzw. die Zellenmatrix sind in mechanischer und elektrischer Hinsicht und auch in der Lichtumwandlungsfunktion empfindlich. Andererseits sind diese Teile und auch der Fertigungsprozess teuer. Der Ausfall oder auch die Beeinträchtigung einer einzigen Solarzelle kann bereits zu einer wesentlichen Wertminderung oder sogar zu Ausschuss des kompletten Solarmoduls führen. Durch die Prüfungsmöglichkeit und die damit koppelbare Nachbearbeitungsmöglichkeit können die Wertverluste wesentlich reduziert und die Ausschussrate gemindert werden.

Die Prüftechnik ermöglicht es, die empfindlichen Solarmodulteile bzw. Werkstückteile sicher und schonend zu handhaben und Fehlereinflüsse zu vermeiden. Insbesondere wird der Lagenaufbau geschont und eine vom Prüfprozess ausgehende negative Beeinträchtigung der Solarmodul- oder Werkstückteile vermieden. Die Prüftechnik ermöglicht es insbesondere, das plattenartige Solarmodul bzw. Werkstück in ebener Ausrichtung zu prüfen und Durchbiegungen zu vermeiden. Die Prüfung kann berührungslos erfolgen. Die Prüfeinrichtung erlaubt auch Erschütterungen des Solarmoduls und evtl. hierdurch hervorgerufene Verschiebungen der Solarzellenanordnung zu vermeiden. Hierfür kann eine am inneren Modul- oder Plattenbereich angreifende Stützeinrichtung vorgesehen sein.

Durch den Lagenaufbau mit der unten liegenden durchsichtigen Grundplatte und der oben liegenden Deckfolie wird von der Prüftechnik eine optische Erfassung und Prüfung des Solarmoduls mit Blickrichtung auf dessen durchsichtige Unterseite durchgeführt. Die von der Stützeinrichtung überdeckten Bereiche können bei dem von der Unterseite erfassten Prüfbild sichtbar gemacht werden. Das Prüfbild kann trotz der Stützeinrichtung den gesamten zu prüfenden Modul- oder Werkstückbereich beinhalten. Diese Prüf- und Bildbereiche können bei einem Solarmodul die gesamte Zellenanordnung und damit fast die gesamte Unterseitenfläche umfassen. Bei anderen Werkstücken können auch Teilflächenbereiche erfasst werden.

Die Sichtbarmachung des von der Stützeinrichtung abgedeckten Bereichs ist auf unterschiedliche Weise möglich. In der einfachsten Ausführung kann die Stützeinrichtung durchsichtig sein und z.B. aus einem durchsichtigen Kunststoffmaterial zumindest in diesem Abdeckungsbereich bestehen. Eine andere Lösungsmöglichkeit sieht eine bewegliche und ggf. ortsveränderliche Stützeinrichtung vor, wobei mehrere Teilbilder der Unterseite aufgenommen und zu einem Prüfbild in geeigneter Weise, z.B. mit einer Bildbearbeitung, z.B. einem sog. Stitching, passgenau zusammengesetzt werden. Bei diesen Teilbildern können die gerade von der Stützeinrichtung beaufschlagten Unterseitenbereiche ausgespart werden.

In einer anderen Variante können die Teilbilder die Stützeinrichtung beinhalten, wobei diese nachträglich bei einer Bildbearbeitung wieder ausgeblendet und durch einen nicht abgedeckten Bereich eines anderen Teilbildes an gleicher Stelle ersetzt wird. Hierbei wird ein Compositbild durch deckungsgleiches Übereinanderlegen der Teilbilder geschaffen.

Die Prüftechnik bietet die Möglichkeit für unterschiedliche optische Prüfungen. Dies kann eine Sichtprüfung mit Auflicht gegen die Unterseite sein, wobei die optische Erscheinungsform der Modul- oder Werkstückteile, insbesondere der Solarzellen und der Zellenanordnung geprüft wird. Ein anderer zusätzlicher oder alternativer Test kann eine Durchlichtprüfung mit einem geeigneten und ggf. für das menschliche Auge unsichtbaren Licht, z.B. Infrarotlicht, sein. Ferner kann alternativ oder zusätzlich eine Luminiszenzprüfung durchgeführt werden, wobei an die Solarzellenanordnung eine elektrische Spannung angelegt und die Solarzellen zum Selbstleuchten angeregt werden. Bei der Durchlicht- und Luminiszenzprüfung können etwaige innere Fehler der Solarzellen, z.B. Risse, Brüche, elektrisch nicht leitende Bereiche oder dgl. durch Schattenbildung erkannt werden. Auch Stromunterbrechungen durch fehlerhafte elektrische Verbindung zwischen den Solarzellen sind detektierbar.

Die optische Erfassungseinrichtung kann ein optisches Erfassungsgerät, z.B. eine digitale Messkamera, aufweisen, die eine geeignete Auflösung hat und die ggf. über einen Spiegel auf die besagte Unterseite blickt. Der Empfindlichkeitsbereich des optischen Erfassungsgeräts kann für alle vorgenannten Prüfverfahren geeignet sein.

Die Stützeinrichtung kann vorteilhafterweise eine Mehrfachfunktion haben und kann als Förderer, z.B. als Gurtförderer, ausgebildet sein. Für die Ortsveränderung kann eine Versatzeinrichtung mit einer Entlastungseinrichtung vorhanden sein, die ein Bewegen, insbesondere seitliches Verschieben, des Förderers gegenüber einem anderweitig, z.B. randseitig abgestützten Solarmodul ermöglicht, ohne dieses zu erschüttern, in seiner Lage zu verändern oder in sonstiger Weise zu beeinträchtigen. Zugleich kann bei diesem Versatz die Abstützfunktion zum Vermeiden oder Mindern eines Durchhangs erhalten bleiben.

Die Begutachtung des Solarmoduls oder Werkstücks kann durch einen Bediener oder automatisch durch eine entsprechend ausgerüstete Bildauswertung in Verbindung mit einer geeigneten Steuerung erfolgen. Eine zur Bildauswertung und ggf. Bildbearbeitung geeignete Auswerteeinrichtung kann dem optischen Erfassungsgerät oder einem externen Kontrollstand zugeordnet sein.

In den Unteransprüchen sind weitere vorteilhafte Ausgestaltungen der Erfindung angegeben.

Die Erfindung ist in den Zeichnungen beispielsweise und schematisch dargestellt. Im Einzelnen zeigen:
- Figur 1:: eine schematische Draufsicht auf eine Fertigungseinrichtung für Solarmodule mit einer Assemblingeinrichtung und einer Prüfeinrichtung,
- Figur 2:: eine vergrößerte Draufsicht auf eine Prüfeinrichtung gemäß Figur 1,
- Figur 3:: eine perspektivische Ansicht einer Prüfeinrichtung von Figur 1 und 2,
- Figur 4:: eine Seitenansicht der Prüfeinrichtung gemäß Pfeil IV von Figur 3,
- Figur 5:: eine weitervergrößerte Draufsicht auf einen Teilbereich der Prüfeinrichtung,
- Figur 6:: eine vereinfachte Unteransicht eines Solarmoduls im Prüfbereich,
- Figur 7:: eine perspektivische Ansicht einer Fördereinrichtung,
- Figur 8:: eine ausschnittsweise Darstellung einer Solarzellenanordnung,
- Figur 9:: einen ausschnittsweisen Längsschnitt durch ein mehrlagiges Solarmodul und
- Figur 10:: eine ausschnittsweise Seitenansicht einer Stützeinrichtung mit einer Entlastungseinrichtung in verschiedenen Betriebsstellungen.

Die Erfindung betrifft eine Prüfeinrichtung (2) für Werkstücke (3). Sie betrifft ferner ein Prüfverfahren und eine Fertigungseinrichtung (1) für derartige Werkstücke (3).

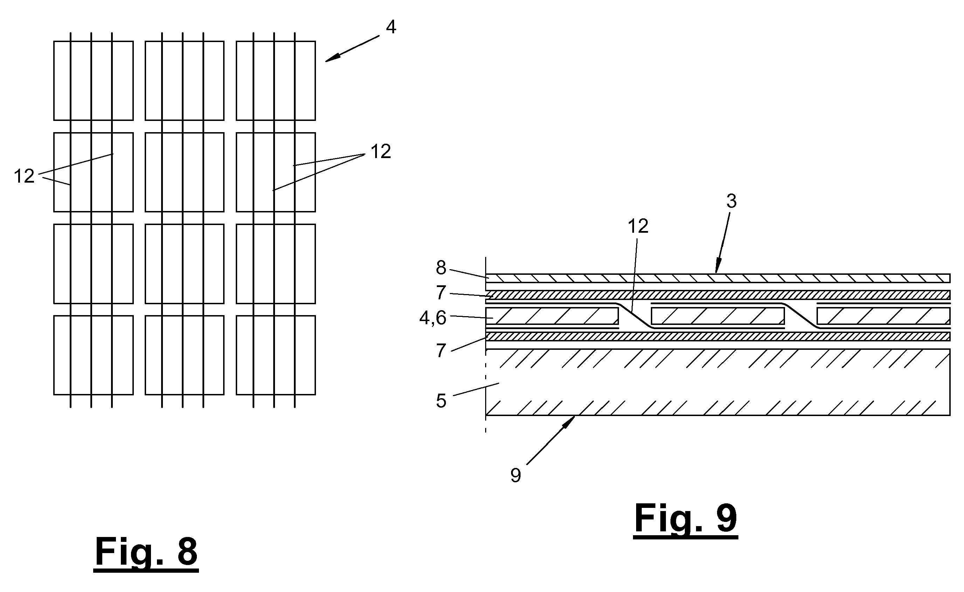

Die Werkstücke (3) sind in der gezeigten Ausführungsform als mehrlagige Solarmodule ausgebildet, die auch als Photovoltaikelemente bezeichnet werden und die in Figur 8 und 9 in ihrem Aufbau schematisch dargestellt sind. Nachfolgend wird bei der Erläuterung auf ein Solarmodul (3) Bezug genommen. Die Angaben geltend entsprechend auch für andere empfindliche und insbesondere mehrlagige Werkstücke (3).

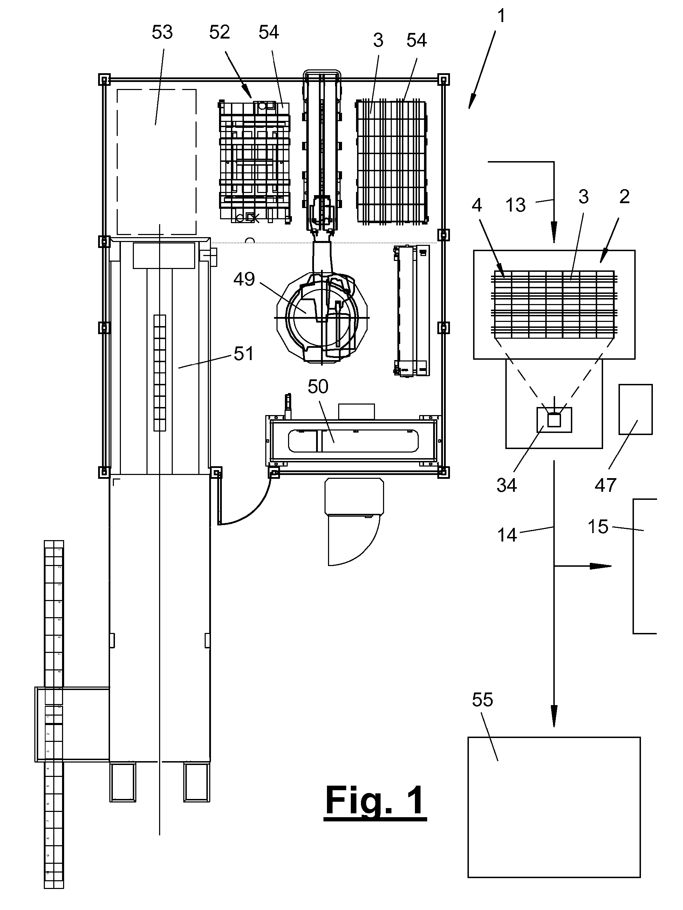

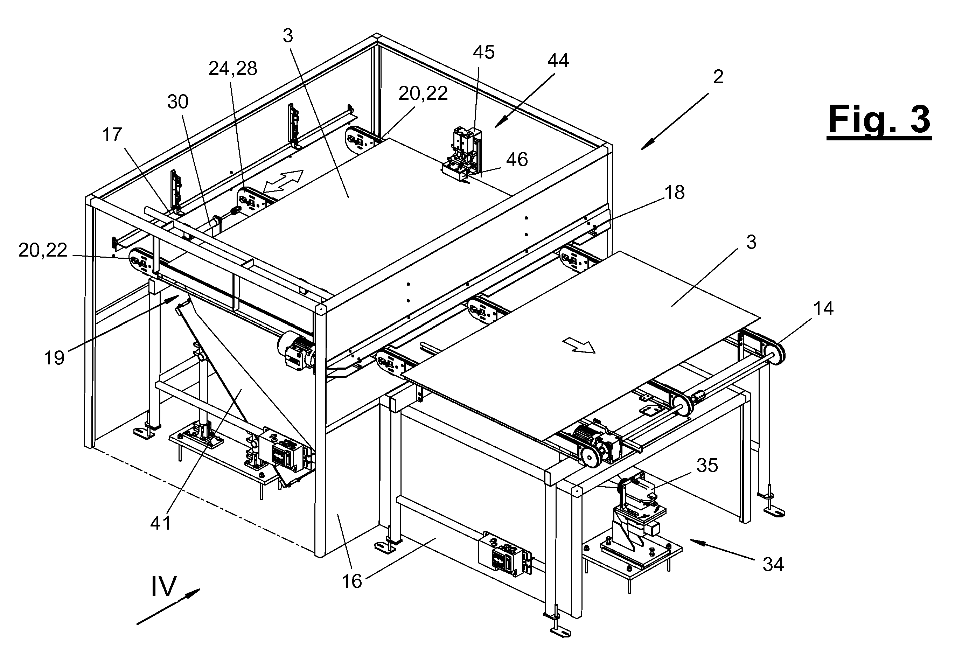

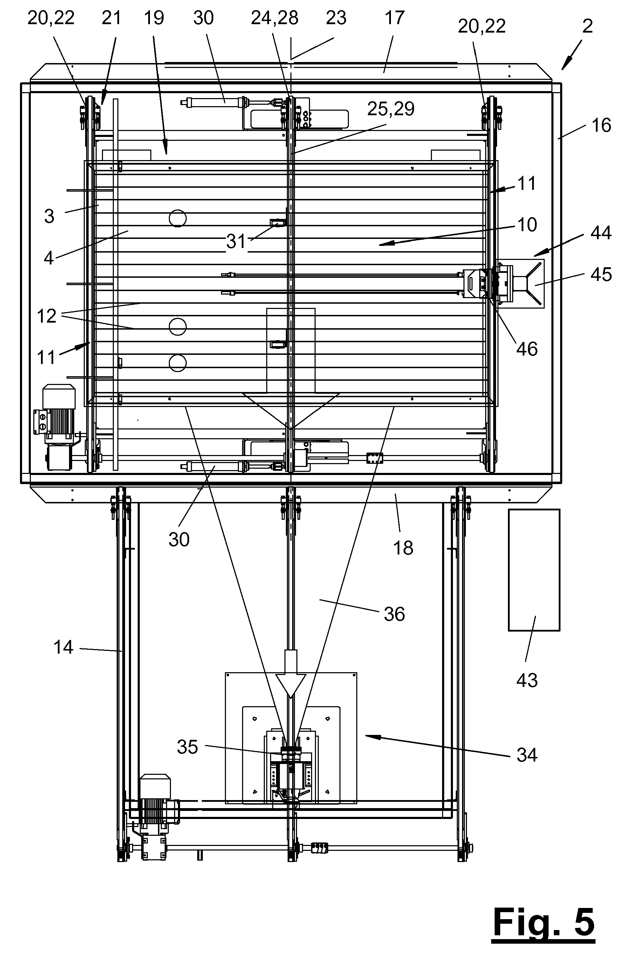

Das Solarmodul (3) ist plattenförmig ausgebildet und hat z.B. in der Draufsicht eine Rechteckform, wie sie in Figur 1 bis 6 dargestellt ist. Das Solarmodul (3) beinhaltet eine Solarzellenanordnung (4), die in Figur 8 schematisch und ausschnittsweise gezeigt ist. Sie besteht aus einer geeigneten Anordnung, z.B. einer regelmäßigen Matrix von Solarzellen, die in mehreren Reihen hintereinander und nebeneinander angeordnet sind und die untereinander durch elektrisch leitende Verbindungselemente (12), z.B. sog. Bändchen, elektrisch verbunden und z.B. in Reihe geschaltet sind. Sie können dabei gemäß Figur 9 abwechselnd an der Ober- und Unterseite der Solarzellen angeordnet sein.

Bei einem in der Praxis üblichen Herstellungsprozess werden die Solarzellen unter Bildung eines sog. Strings in einer Reihe hintereinander positioniert und miteinander über die Bändchen (12) verbunden. Anschließend werden mehrere Strings zu einer Solarzellenanordnung (4), insbesondere der gezeigten regelmäßigen Matrix, zusammengestellt. Die an den Stirnenden der Strings überstehenden Bändchen (12) werden anschließend miteinander elektrisch leitend verbunden, wobei die Strings in der gewünschten Weise elektrisch in Reihe oder parallel geschaltet werden. Am fertigen Solarelement (3) gibt es einen Ausschnitt mit einer Kontaktstelle für einen weiterführenden Stromanschluss des Solarmoduls (3) bzw. der Solarzellenanordnung (4).

Wie Figur 9 im Schnitt verdeutlicht, ist ein Solarmodul (3) mehrlagig aufgebaut. Es besteht aus einer ersten Lage (5), die von einer durchsichtigen Grundplatte, z.B. einer Glasplatte, gebildet wird. Hierauf kann eine weitere Lage (7) in Form einer Einbettungsfolie, insbesondere einer sog. EVA-Kunststofffolie, aufgelegt werden. Auf dieser wiederum wird die Solarzellenanordnung (4) als Lage (6) aufgelegt. Darüber kann sich eine weitere vorerwähnte Lage (7) in Form einer EVA-Folie oder dgl. befinden. Als oberste Lage (8) kann eine Abdeckung, insbesondere eine weitestgehend lichtundurchlässige Deckfolie, aufgelegt werden. Der vorbeschriebene Lagenaufbau kann auch anders sein, wobei einzelne Lagen, insbesondere die Zwischenfolien (7), entfallen oder weitere Lagen hinzukommen können.

Die Lagen (5,6,7,8) liegen im wesentlichen lose und ohne feste gegenseitige Verbindung übereinander. Sie bilden ein sog. Sandwich, welches gegen mechanische Einflüsse, insbesondere Erschütterungen, Biegungen oder dgl. empfindlich ist. Im unfixierten Zustand des Sandwiches können bei solchen äußeren Einflüssen gegenseitige Verschiebungen der einzelnen Lagen und ggf. auch mechanische oder funktionelle Schäden eintreten, insbesondere an der Solarzellenanordnung (4) und an deren Solarzellen sowie Bändchen (12). Dies können z.B. gegenseitige Verschiebungen der Strings, innere und äußere Zellenbrüche, Abplatzer und Splitterung an den Zellenrändern, inaktive Zellenbereich, Schäden und insbesondere fehlerhafte Lötstellen an den Bändchen (12) oder dgl. sein.

Das Sandwich wird am Ende der Herstellung fixiert. Dies geschieht z.B. durch thermisches Verbacken in einem sog. Laminator. Bis zu dieser Fixierung besteht das vorgenannte Beeinträchtigungsproblem bei dem Sandwich.

Figur 1 zeigt schematisch eine Fertigungseinrichtung (1) für ein solches Solarmodul (3). Die Fertigungseinrichtung (1) weist z.B. einen Stringer (51) zur Herstellung der vorgenannten Solarzellen-Strings auf, die dann mit einer Handhabungseinrichtung (49), z.B. einem mehrachsigen Handlingroboter, gegriffen und einer Assemblingeinrichtung (52) zur Bildung der Solarzellenanordnung (4) bzw. Lage (6) zugeführt werden. Die Handhabungseinrichtung (49) kann z.B. aus einem Gelenkarmroboter, einem Linearroboter oder dgl. mit sechs oder mehr Achsen und mit einer geeigneten Greifeinrichtung an der Roboterhand bestehen. Im Arbeitsbereich der Handhabungseinrichtung (49) kann eine Serviceeinrichtung (50) angeordnet sein, die vor dem Assembling ein Prüfen des Strings und ggf. ein Trimmen der Bändchenüberstände an den Stirnenden des Strings vor dem Assembling sowie ein Referenzieren der Handhabungseinrichtung (49) ermöglicht.

Die Assemblingeinrichtung (52) kann eine oder mehrere Auflagen (54) aufweisen, auf denen das vorbeschriebene Sandwich und dessen Lagen (5,6,7,8) nach und nach aufgebaut werden. Die Zuführung der Lagen (5,7,8) kann mittels einer geeigneten Zuführeinrichtung (53), z.B. eines Linearroboters oder Portalroboters, geschehen. Bei negativen Prüfungsergebnissen in der Serviceeinrichtung (50) können fehlerhafte Strings zur Nachbearbeitung von der Handhabungseinrichtung (49) ausgeschleust werden. Die fertigen und noch losen Sandwiches werden anschließend mit einer geeigneten Fördereinrichtung zur Weiterbearbeitung und insbesondere zur endseitigen Fixiereinrichtung (55), insbesondere einem Laminator, transportiert. In dieser Förderstrecke ist eine nachfolgend näher erläuterte Prüfeinrichtung (2) angeordnet, die zur Prüfung des mehrlagigen Solarmoduls (3) oder eines anderen Werkstücks dient. In der Prüfeinrichtung (2) können insbesondere die Solarzellenanordnung (4) bzw. deren Teile geprüft werden. Es können aber auch andere Modul- oder Werkstückbestandteile einer Prüfung unterzogen werden. Die Prüfung ist im gezeigten Ausführungsbeispiel optischer Natur. Sie kann alternativ oder zusätzlich auch auf anderen physikalischen und bevorzugt berührungslosen Prüfverfahren basieren.

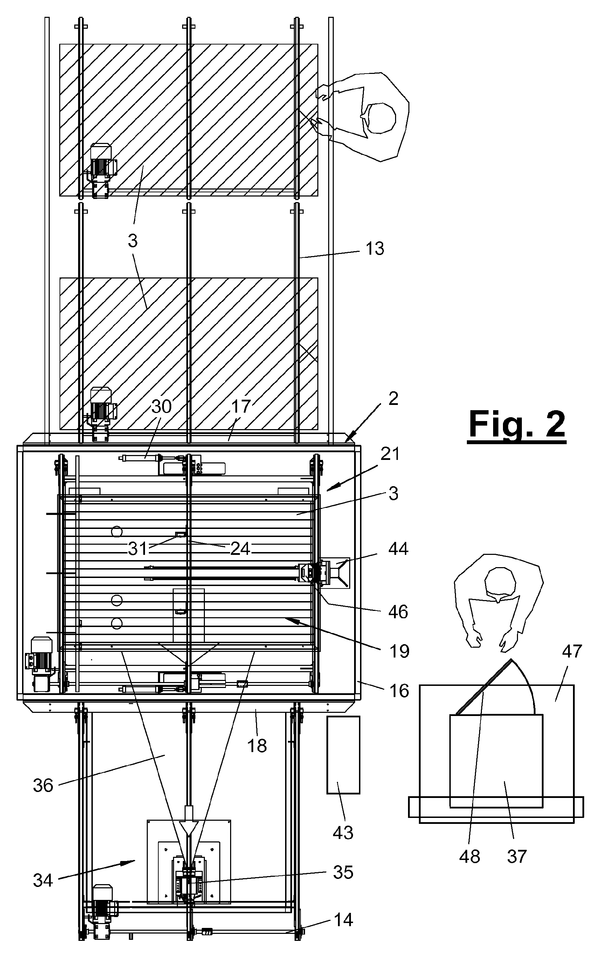

Der Prüfeinrichtung (2) ist ein Kontrollstand (47) zugeordnet, an dem ein Bediener die Prüfergebnisse begutachten und in Abhängigkeit vom Ergebnis entsprechende Maßnahmen einleiten kann. Figur 2 zeigt diese Anordnung mit einer Anzeige (48), z.B. einem Monitor oder dgl. zur Darstellung der Prüfergebnisse. Diese Darstellung kann in Form von Bildern oder von Auswerteergebnissen geschehen. Alternativ oder zusätzlich zum Kontrollstand (47) kann eine vollautomatische Auswertung der Prüfergebnisse in einer geeigneten Steuerung (nicht dargestellt) mit Einleitung entsprechender Maßnahmen stattfinden. Für gut befundene Solarmodule oder Werkstücke (3) werden zum nachfolgenden Laminator (55) weitertransportiert. Falls Fehler des Solarmoduls (3), insbesondere der Solarzellenanordnung (4), festgestellt werden, kann das betreffende Solarmodul (3) in eine schematisch angedeutete Nachbearbeitung (15) ausgeschleust werden. Die Nachbearbeitung kann in einer Reparatur von Fehlern, in einer Demontage des Sandwiches oder in sonstigen Abhilfemaßnahmen bestehen, die manuell oder automatisch durchgeführt werden. Entsprechendes gilt für andere Arten von Werkstücken (3).

Die Prüfeinrichtung (2) ist in Figur 2 bis 7 und 10 näher dargestellt. Sie beinhaltet ein gegen äußeren Lichtzutritt abschirmbares Gehäuse (16) mit einem abdunkelbaren Innenraum und einem dortigen Prüfbereich (19), in den das Solarmodul (3) durch steuerbare Ein- und Auslässe (17,18) eingeführt und abgeführt werden kann. Die Ein- und Auslässe (17,18) können z.B. pneumatisch betätigbare Lichtklappen zum lichtdichten Verschluss der Durchlassöffnung aufweisen. In Transportrichtung vor und hinter dem Gehäuse (16) sind eine Zuführeinrichtung (13) und eine Abführeinrichtung (14) angeordnet, die geeignete Förderer für die Sandwiches bzw. Solarmodule (3) aufweisen. Dies können z.B. Gurtförderer oder dgl. sein, die an den Randbereichen und im mittleren Bereich der Solarmodule (3) angreifen und diese schonend und erschütterungsfrei unter Vermeidung von unerwünschten Durchbiegungen transportieren. Das Gehäuse (16) weist ein Gestell mit innenseitig geschwärzten Wänden auf, die ggf. für Wartungszwecke abnehmbar sind.

Das auf der durchsichtigen Platte (5) aufgebaute Sandwich wird von seiner Unterseite (9) her begutachtet und geprüft. Hierfür ist eine optische Erfassungseinrichtung (34) vorgesehen, die in unterschiedlicher Weise ausgebildet und angeordnet sein kann und in deren Sichtbereich (36) die im Prüfbereich (19) befindliche Unterseite (9) des Solarmoduls (3) liegt. Hierbei kann zu Prüfzwecken die gesamte oder ein wesentlicher Teil der Unterseite (9) optisch erfasst werden. Der Erfassungsbereich betrifft insbesondere die Solarzellenanordnung (4), die in ihrer Gesamtheit optisch geprüft werden kann. Alternativ können auch nur Teilbereiche der Unterseite (9) zu Prüfzwecken erfasst werden. Dies hängt auch von der Art und Ausbildung des Werkstücks (3) und der Lage und Anordnung seiner zu prüfenden Bestandteil ab.

Im Prüfbereich (19) wird das Solarmodul (3) in einer im wesentlichen horizontalen Lage gehalten. Dies kann z.B. durch eine Abstützung (20) an den seitlichen Randbereichen (11) des Solarmoduls (3) geschehen, die sich in der durch Pfeile symbolisierten Transportrichtung erstrecken. Ein Durchhang bzw. eine Durchbiegung des Solarmoduls (3) bzw. des Sandwiches wird durch eine Stützeinrichtung (24) verhindert, die im inneren Bereich (10) des Solarmoduls oder Sandwiches (3) an ein oder mehreren Angriffstellen (26) von unten her angreift und abstützt.

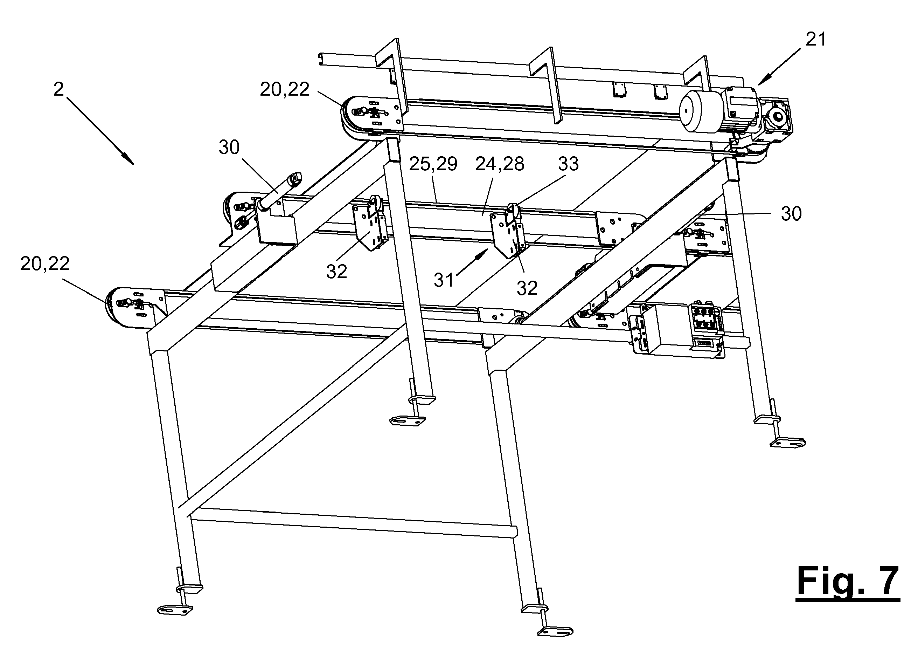

Die Prüfeinrichtung (2) kann eine Fördereinrichtung (21) im Gehäuse (16) aufweisen. Diese ermöglicht in Verbindung mit der Zuführ- und Abführeinrichtung (13,14) einen taktweisen Transport der Solarmodule (3) durch die Prüfeinrichtung (2) und kann das Solarmodul (3) im Prüfbereich (19) positionieren. Die Abstützungen (20) und die Stützeinrichtung (24) können als Bestandteile der Fördereinrichtung (21) und als Förderer (22,28) ausgebildet. Diese Förderer (22,28) können parallel ausgerichtet sein und können eine entsprechend geeignete Ausbildung für einen schonenden und erschütterungsfreien Modultransport haben. Im gezeigten Ausführungsbeispiel sind sie als umlaufende Gurtförderer ausgestaltet. Figur 7 zeigt die Anordnung der Förderer (22,28) mit ihrem Antrieb an einem gemeinsamen Gestell oder Rahmen.

Die optische Erfassungseinrichtung (34) weist ein optisches Erfassungsgerät (35) auf, welches in beliebig geeigneter Weise ausgebildet sein kann, z.B. als digitale Messkamera. Das Erfassungsgerät (35) kann mehrteilig ausgebildet oder mehrfach angeordnet sein. In den Ausführungsbeispielen ist eine digitale Messkamera mit einem Bildsensor dargestellt, der eine hohe Auflösung und ein großes Lichtempfindlichkeitsspektrum hat. Das Erfassungsgerät (35) kann Bilder mit sichtbarem Licht und ggf. mit unsichtbarem Licht, insbesondere Infrarotlicht, aufnehmen, speichern und mit einer integrierten oder an anderer Stelle, z.B. am Kontrollstand (47), angeordneten Auswerteeinrichtung (37) auswerten. Hierbei kann eine Bildauswertung zur Erkennung und Lokalisierung etwaiger Fehler des Solarmoduls (3) stattfinden. Insbesondere können hierdurch die Art des Fehlers und der betroffene Modulteil, insbesondere eine Solarzelle oder ein Bändchen (12), identifiziert werden. Für unterschiedliche Lichtarten können unterschiedliche Erfassungsgeräte (35) eingesetzt werden.

Das optische Erfassungsgerät (35) blickt auf die besagte Unterseite (9) des Solarmoduls (3). Dies kann auf direktem Wege oder durch eine Bildumlenkung mittels eines schrägen Spiegels (41) oder auf andere Weise geschehen. Im gezeigten Ausführungsbeispiel ist das optische Erfassungsgerät (35) horizontal ausgerichtet und im Bodenbereich der Prüfeinrichtung (2) in einem Gehäuseteil vor dem Prüfbereich (19) angeordnet und blickt über den Spiegel (41) auf die Unterseite (9). Hierdurch ergibt sich ein für die Bilderfassung günstiger verlängerter Abstand zwischen Objektiv und Unterseite (9). In der gezeigten Ausbildung kann das optische Erfassungsgerät (35) die gesamte innerhalb der randseitigen Förderer (22) liegende Unterseite (9) sehen.

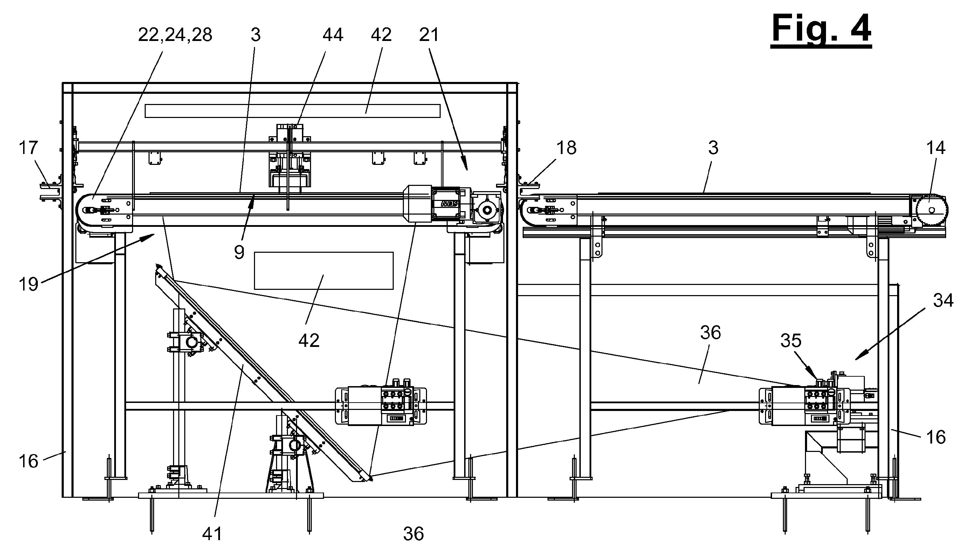

Die Prüfeinrichtung (2) kann eine in Figur 4 schematisch angedeutete Beleuchtungseinrichtung (42) aufweisen, die für eine oder mehrere Beleuchtungsarten vorgesehen sein kann und die einteilig oder mehrteilig ausgebildet sein kann. Die Solarzellenanordnung (4) kann z.B. durch die durchsichtige Unterseite (9) mittels Auflicht beleuchtet und optisch erfasst werden. Hierfür kann eine geeignete Beleuchtung (42) im Bereich unterhalb des Solarmoduls (3) angeordnet sein, die ein vorzugsweise schattenfreies Licht auf die gesamte Unterseite (9) oder auf Teilbereiche hiervon wirft. Hierfür können z.B. Leuchtelemente, insbesondere LEDs oder dgl., mit vorgeschalteten opaken Streuscheiben oder anderen Diffusionseinrichtungen vorgesehen sein. Dieser Teil der Beleuchtung (42) kann mit schräger Strahlrichtung seitlich und unterhalb vom Solarmodul (3) und/oder mit im wesentlichen vertikaler Strahlrichtung direkt unterhalb des Solarmoduls (3) und ggf. eines teildurchlässigen Spiegels (41) angeordnet sein. In einer weiteren Variante kann eine Beleuchtung (42) als Ringbeleuchtung rund um das optische Erfassungsgerät (35) angeordnet sein und in Blickrichtung strahlen.

Mit Auflicht können Oberflächenfehler der Solarzellenanordnung (4) und ihrer Teile optisch erfasst, identifiziert und lokalisiert werden. Dies können z.B. Oberflächenfehler oder Ausbrüche der Solarzellen, fehlende oder beschädigte Bändchen (12) oder dgl. sein. Auch evtl. Ausrichtungs- und Lagefehler der Solarzellen bzw. der Strings innerhalb der Solarzellenanordnung (4) können detektiert werden.

Alternativ oder zusätzlich kann eine Prüfung mit Durchlicht stattfinden, wobei eine geeignete Beleuchtungseinrichtung (42) oder ein Teil hiervon oberhalb des Prüfbereichs (19) und des Solarmoduls (3) angeordnet ist. Auch hier kann mit schattenfreiem Licht gearbeitet werden. Das Durchlicht durchdringt die oberste Lage bzw. Deckfolie (8) und die anderen Sandwichlagen und kann z.B. Infrarotlicht sein. Alternativ können andere Wellen- oder Strahlungsformen, z.B. Gammastrahlung, Betastrahlung oder dgl. eingesetzt werden, welche die zu prüfenden Modulteile, insbesondere die Solarzellenanordnung (4), durchdringen und beim Durchgang innere Fehler erkennbar machen. Dies können innere Risse oder Brüche oder sonstige Defekte in den Solarzellen und/oder den Bändchen (12) sein. Mit Durchlicht können auch die Konturen und Lagen der Solarzellen und der Bändchen (12) optisch erfasst werden. Die Defekte äußern sich z.B. in Hell/Dunkel-Unterschieden.

Im weiteren ist es alternativ oder zusätzlich möglich, einen Luminiszenztest der Solarzellenanordnung (4) durchzuführen. Zu diesem Zweck ist im Prüfbereich (19) eine Kontaktiereinrichtung (44) für den eingangs erwähnten elektrischen Anschluss des Solarmoduls (3) bzw. der Solarzellenanordnung (4) vorgesehen, die mit einer geeigneten elektrischen Stromversorgung (43) in Verbindung steht. Die steuerbare und schaltbare Kontaktiereinrichtung (44) weist z.B. ein seitlich neben dem Prüfbereich (19) stehendes Gestell (45) mit einem steuerbaren Kontaktkopf (46) auf. Dieser ist z.B. höhenverstellbar und kann erschütterungsfrei an das Solarmodul (3) angenähert und mit seinem Kontaktelementen gegen die freigelegten Stromanschlüsse im Deckfolienausschnitt des Solarmoduls (3) zu Prüfzwecken angedrückt werden, wobei das Solarmodul (3) sich am randseitigen Förderer (22) oder einer anderen Abstützung (20) abstützt. Zu Transportzwecken kann der Kontaktkopf (46) wieder entfernt werden.

Bei der Luminiszenzprüfung werden die Solarzellen durch die angelegte elektrische Spannung zum Leuchten angeregt. Hierbei werden durch hell/dunkel-Unterschiede ebenfalls innere Defekte der Solarzellen und/oder der Bändchen (12) sichtbar, z.B. Risse, Brüche, elektrisch nicht leitende oder anderweitig inaktive Zellenbereiche, unterbrochene Bändchen (12), tote Lötstellen oder dgl..

Mit der optischen Erfassungseinrichtung (34) können die vorbeschriebenen Prüfungen mit Auflicht, Durchlicht und/oder Luminiszenz in beliebiger Kombination durchgeführt werden. Hierbei werden jeweils Prüfbilder (40) einzeln oder gemeinsam aufgenommen, ausgewertet und gespeichert. Dies kann für die verschiedenen Lichtarten in getrennten Prüfbildern (40) geschehen. Die Prüfbilder und/oder die Auswerteergebnisse können einer übergeordneten Steuerung mitgeteilt und einem Datensatz für das jeweilige Solarmodul (3) beigefügt werden. Die Bewertung der Prüfergebnisse und die hiervon abgeleitete Entscheidung über Fixierung oder Nachbearbeitung kann in der vorgenannten Weise von einem Bediener oder maschinell von einer geeigneten Einrichtung, insbesondere der Auswerteeinrichtung (37), getroffen werden.

Die Stützeinrichtung (24) befindet sich an der Unterseite (9) und liegt im Sichtfeld (36) der optischen Erfassungseinrichtung (34), wobei ein oder mehrere Bereiche (27) an der Unterseite (9) von der darunter angeordneten Stützeinrichtung (24) abgedeckt werden. Die Prüfeinrichtung (2) ermöglicht es, auch diese abgedeckten Bereiche (27) sichtbar und einer Prüfung zugänglich zu machen.

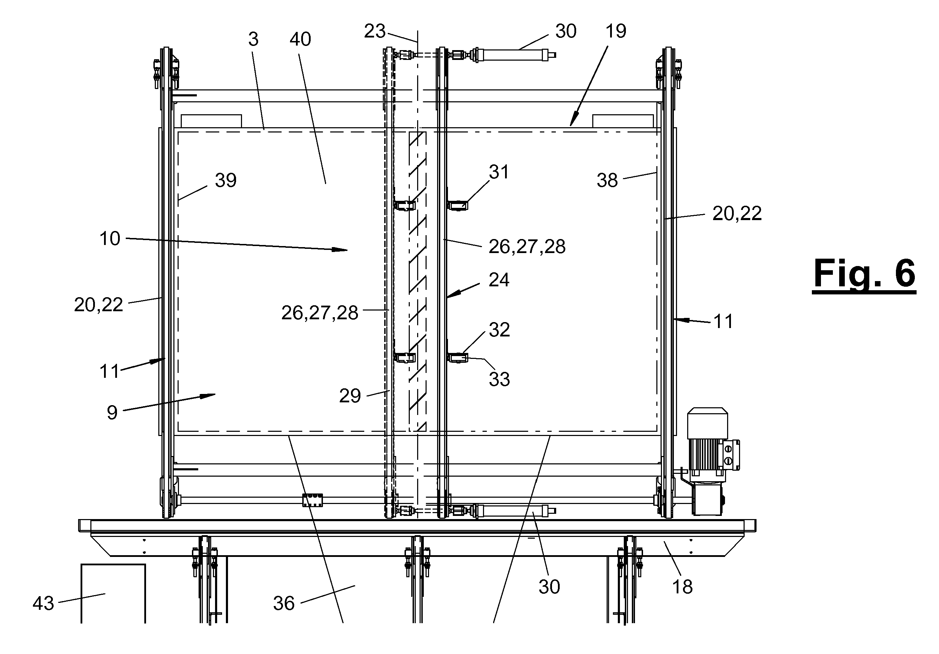

In dem gezeigten Ausführungsbeispiel ist zu diesem Zweck die undurchsichtige Stützeinrichtung (24) beweglich und kann ihre Lage relativ zum vorzugsweise ruhenden und randseitig abgestützten Solarmodul (3) ändern. Durch diese Lageänderung oder Ortsveränderung wechseln die Angriffsstellen (26) und die abgedeckten Bereiche (27) ebenfalls ihre Lage. Figur 6 verdeutlicht dies und zeigt, dass die wechselnd abgedeckten Bereiche (27) bzw. die Angriffsstellen (26) beidseits der Mitte (23) des Solarmoduls (3) bzw. seiner Unterseite (9) angeordnet sind. Die Kinematik der Lage- oder Ortsveränderung kann beliebig sein und in einem Verschwenken oder dem gezeigten Verschieben bestehen.

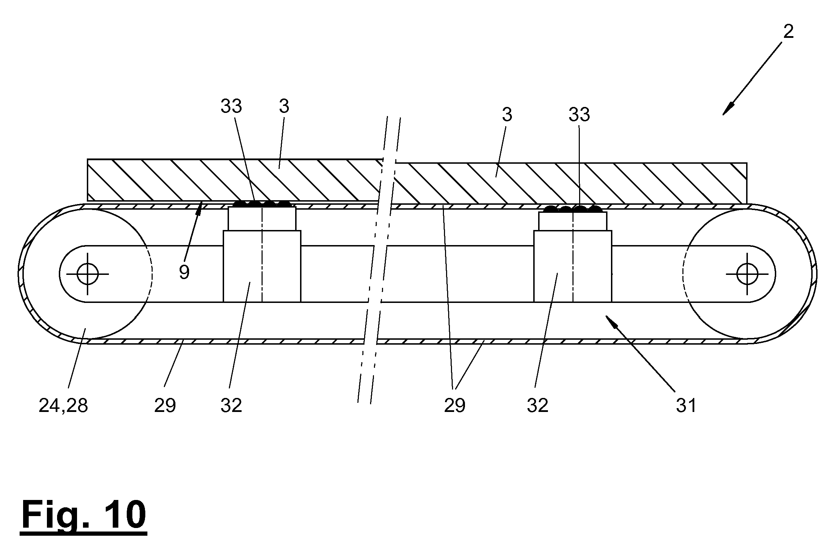

Das an der Unterseite (9) angreifende Stützelement (25) der gezeigten Stützeinrichtung (24) ist ein längs laufender Gurt (29), der an der Unterseite von Tragteilen des Förderers (28) abgestützt ist und auf dem zu Transportzwecken des Solarmodul (3) aufliegt, wie dies in der rechten Bildhälfte von Figur 10 dargestellt ist.

Der Ortswechsel bzw. die Lageänderung der Stützeinrichtung (24) erfolgt durch eine Versatzeinrichtung (30), die für eine Verstellung oder Verschiebung quer zur Transportrichtung sorgt und die z.B. pneumatische Zylinder, elektrisch angetriebene Spindeln oder dgl. Stellelemente aufweist. Der Förderer (28) kann hierbei auf zwei endseitigen Querstangen quer verschoben werden und hat hierfür entsprechende Lagerbuchsen. Eine der Querstangen kann allen drei Förderern (22,28) zugeordnet und mit einem Antriebsmotor verbunden sein. Sie dient dann zugleich als Antriebswelle für die Förderer (22,28). Figur 4 bis 7 zeigen die Fördereinrichtung (21) in verschiedenen Ansichten.

Um einen störungsfreien und insbesondere erschütterungsfreien Querversatz der Stützeinrichtung (24) zu ermöglichen, weist diese eine Entlastungseinrichtung (31) auf, die in Figur 7 und 10 schematisch dargestellt ist. Sie besteht aus einer oder mehreren am Förderergestell angeordneten Hubeinrichtungen (32), die seitlich neben dem Gurt (29) angeordnet sind und die gehoben und gesenkt werden können. An der Oberseite tragen sie ein geeignetes reibungsarmes Tragelement (33). Dies kann z.B. der in Figur 10 gezeigte Gleitkopf mit einem Kugelkissen sein. Alternativ ist die in Figur 7 dargestellte Ausbildung des Tragelements (33) als leichtgängige Rolle möglich. Andere Varianten sind Luftkissen oder dgl..

Durch die Entlastungseinrichtung (31) wird das Solarmodul (3) ein kleines Stück vom Gurt (29) abgehoben oder zumindest entlastet, wodurch die Stützeinrichtung (24) ohne Reibwiderstand am Gurt (29) an der Unterseite (9) verschoben werden kann. In der Endlage kann das Solarmodul (3) wieder auf den Gurt (29) abgesenkt werden. Bei der Zu-und Abfuhr von Solarmodul (3) in und aus dem Prüfbereich (19) kann die Stützeinrichtung (24) die in Figur 2 gezeigte Mittelstellung einnehmen und mit den anderen Förderern (13,14) fluchten. Für die Bilderfassung kann sie die in Figur 6 gezeigten außermittigen Stellungen links und rechts einnehmen.

Die optische Erfassungseinrichtung (34) nimmt Teilbilder (38,39), insbesondere zwei oder mehr solcher Teilbilder von der Unterseite (9) auf und erzeugt hieraus mittels der Auswerteeinrichtung (37) ein zusammengesetztes Prüfbild (40), in dem die Stützeinrichtung (24) eliminiert und die abgedeckten Bereiche (27) sichtbar gemacht sind. In der gezeigten Ausführungsform werden hierfür gemäß Figur 6 ein erstes rechtes Teilbild (38) und ein zweites linkes Teilbild (39) aufgenommen. Bei der Aufnahme des rechten Teilbilds (38) befindet sich die Stützeinrichtung (24) in der gestrichelt dargestellten Lage links von der Mitte (23), sodass der Unterseitenbereich vom rechten Rand bis zur Mitte (23) frei und nicht abgedeckt ist. Für die Aufnahme des linken Teilbilds (39) wechselt die Stützeinrichtung (24) in die mit durchgezogenen Strichen dargestellte rechte Lage jenseits der Mitte (23), wobei auch dieses Teilbild (39) keine abgedeckten Bereiche (27) aufweist.

Die Teilbilder (38,39) können an der Mitte (23) exakt zusammenstoßen und zum Prüfbild (40) zusammengesetzt werden. Sie können einander auch im Bereich der Mitte (23) überlappen, was in Figur 6 durch eine Schraffur angedeutet ist. Die Teilbilder (38,39) stellen Ausschnitte der Unterseite (9) dar. Die Ausschnittbildung kann auf verschiedene Weise erfolgen. Zum einen kann durch eine Blende oder dgl. der Sichtbereich (36) des optischen Erfassungsgeräts (35) entsprechend eingeengt werden. Ferner ist es möglich, die Ausschnittsbildung nachträglich durch eine Bildauswertung und die Auswerteeinrichtung (37) vorzunehmen. Hierbei wird mit jedem Teilbild (38,39) die gesamte Unterseite (9) einschließlich der jeweils abgedeckten Bereiche (27) erfasst, wobei die Bildhälfte mit dem abgedeckten Bereich (27) durch eine Bildauswertung abgeschnitten und gelöscht wird. Ein Zusammensetzen der Teilbilder (38,39) ist durch Auswertung ihrer charakteristischen Bildbestandteile im Stoßbereich, insbesondere in der Mitte (23), möglich, wobei diese charakteristischen Bestandteile durch evtl. Bildverschiebung miteinander zur Deckung gebracht und aus den Teilbildern (38,39) ein komplettes Prüfbild (40) ohne abgedeckte Bereiche (27) zusammengesetzt wird.

In einer anderen Variante ist es möglich, Teilbilder (38,39) von der gesamten oder einem Großteil der Unterseite (9) einschließlich der abgedeckten Bereiche (27) aufzunehmen, wobei anschließend mit einer Bildauswertung die abgedeckten Bereiche (27) detektiert und gelöscht werden. Die Teilbilder (38,39) werden dann zu einem Composit-Prüfbild (40) deckungsgleich übereinander gelegt.

In weiterer Abwandlung sind andere Möglichkeiten der Bildauswertung unter Eliminierung der abgedeckten Bereiche (27) gegeben. Dies kann z.B. durch Ausblenden entsprechender Bildbereiche geschehen. Ferner können bei der Bildauswertung die abgedeckten Bereiche (27), die eine von der Stützeinrichtungskontur abhängige und gleichbleibende Form haben, detektiert und als Objekt erkannt sowie gelöscht oder bei der weiteren Bildauswertung unberücksichtigt gelassen werden.

In einer weiteren und nicht dargestellten Variante ist es möglich, die Stützeinrichtung (24) in anderer Weise konstruktiv auszubilden und die in den Sichtbereich (36) ragenden Vorrichtungsteile aus einem durchsichtigen Material, z.B. einem transparenten Kunststoff, herzustellen. Die optische Erfassungseinrichtung (34) kann in diesem Fall durch die Stützeinrichtung (24) hindurch blicken. Die Stützeinrichtung (24) braucht je nach Anforderungen an die Erfassungs- und Prüfgenauigkeit in einem solchen Fall u.U. keine Lage-oder Ortsveränderungen auszuführen.

In einer weiteren Abwandlung ist es möglich, dass die Stützeinrichtung (24) nicht als Förderer, sondern nur als reines Stützmittel ausgebildet ist. Zu diesem Zweck kann sie z.B. ein oder mehrere Hubstempel, Schwenkarme oder dgl. steuerbare Stellmittel mit endseitigen Stützelementen (25) aufweisen, die an geeigneten Angriffsstellen (26) an der Unterseite (9) stützend angreifen.

Das optische Erfassungsgerät (35) bzw. die Auswerteeinrichtung (37) können die erfassten Bilder vermessen und dabei die unterschiedlichen Bildbestandteile erkennen und auswerten. Für eine Vermessung und einen Vergleich mit vorgegebenen Ausrichtungen oder Positionen der Solarzellenanordnung (4) und ihrer Bestandteile können im Prüfbereich (19) und im Sichtbereich (36) Positionsmarken beweglich angebracht werden. Hierdurch lassen sich Absolutpositionen und Lagebeziehungen feststellen. Ansonsten können Relativpositionen und relative Lagebezüge bei der Vermessung festgestellt und ausgewertet werden. Dies kann ggf. genügen, so dass auf Positionsmarken (nicht dargestellt) verzichtet werden kann.

Abwandlungen der gezeigten und beschriebenen Ausführungsformen sind in verschiedener Weise möglich. Die vorbeschriebenen Einzelteile der Prüfeinrichtung (2) und der Fertigungseinrichtung (1) können in beliebiger Weise miteinander kombiniert und gegeneinander ausgetauscht werden. Ferner sind konstruktive Abwandlungen der Prüfeinrichtung (2) und ihrer Komponenten sowie auch der anderen Teile der Fertigungseinrichtung (1) möglich. Die Fördertechnik kann in anderer Weise ausgebildet sein. Für andere Arten von Werkstücken (3) kann eine andere Lage und Ausrichtung des Prüfbereichs (19) vorgesehen sein. Die Horizontallage ist vor allem für empfindliche Werkstücke (3) von Vorteil, die z.B. eine labile Struktur, insbesondere einen losen Lagenaufbau haben. Auch die Anordnung und Blickrichtung der optischen Erfassungseinrichtung (34) sowie ihrer Bestandteile kann abgewandelt werden.

### BEZUGSZEICHENLISTE

- 1: Fertigungseinrichtung
- 2: Prüfeinrichtung
- 3: Werkstück, Solarmodul, Photovoltaikelement
- 4: Solarzellenanordnung, Solarzellenmatrix
- 5: Lage, Platte durchsichtig
- 6: Lage, Zellenanordnung
- 7: Lage, Folie
- 8: Lage, Abdeckung, Deckfolie
- 9: Unterseite
- 10: innerer Bereich
- 11: Randbereich
- 12: Leitung, Bändchen
- 13: Zuführeinrichtung, Förderer
- 14: Abführeinrichtung, Förderer
- 15: Nachbearbeitung
- 16: Gehäuse
- 17: Einlass
- 18: Auslass
- 19: Prüfbereich
- 20: Abstützung
- 21: Fördereinrichtung
- 22: Förderer randseitig
- 23: Mitte
- 24: Stützeinrichtung
- 25: Stützelement
- 26: Angriffsstelle
- 27: abgedeckter Bereich
- 28: Förderer im Innenbereich
- 29: Gurt
- 30: Versatzeinrichtung
- 31: Entlastungseinrichtung
- 32: Hubeinrichtung
- 33: Tragelement, Gleitkopf
- 34: Erfassungseinrichtung
- 35: optisches Erfassungsgerät, Kamera, Messkamera
- 36: Sichtbereich
- 37: Auswerteeinrichtung
- 38: Teilbild
- 39: Teilbild
- 40: zusammengesetztes Bild, Gesamtbild
- 41: Spiegel
- 42: Beleuchtungseinrichtung
- 43: Versorgungsanschluss, Stromanschluss
- 44: Kontaktiereinrichtung
- 45: Gestell
- 46: Kontaktkopf
- 47: Kontrollstand
- 48: Anzeige
- 49: Handhabungseinrichtung, Handlingroboter
- 50: Serviceeinrichtung
- 51: Stringer
- 52: Assemblingeinrichtung
- 53: Zuführeinrichtung, Linearroboter
- 54: Auflage
- 55: Fixiereinrichtung, Laminator

## Patentansprüche

1. Prüfeinrichtung für ein mehrlagiges Solarmodul (3) mit einer Solarzellenanordnung (4), wobei die Prüfeinrichtung (2) eine randseitige Abstützung (20) für das Solarmodul (3) sowie eine an einem inneren Bereich (10) der Unterseite (9) des Solarmoduls (3) angreifende Stützeinrichtung (24) und eine auf die Unterseite (9) blickende optische Erfassungseinrichtung (34) aufweist, die ein die Solarzellenanordnung (4) enthaltendes Prüfbild (40) der Unterseite (9) erzeugt, an dem der von der Stützeinrichtung (24) abgedeckte Bereich (24) sichtbar gemacht ist, wobei die Stützeinrichtung (24) beweglich ist und wechselnde Bereiche (27) der Unterseite (9) abdeckt.

2. Prüfeinrichtung Anspruch 1, **dadurch gekennzeichnet, dass** für die Lageänderung der Stützeinrichtung (24) eine Versatzeinrichtung (30) vorgesehen ist.

3. Prüfeinrichtung nach Anspruch 1 oder 2, **dadurch gekennzeichnet, dass** die optische Erfassungseinrichtung (34) Teilbilder (38,39) unter Einschluss der Stützeinrichtung (24) erzeugt und zu einem Prüfbild (40) übereinander legt, wobei die Stützeinrichtung (24) ausgeblendet und die abgedeckten Bereiche (27) sichtbar gemacht sind.

4. Prüfeinrichtung nach Anspruch 1, 2 oder 3, **dadurch gekennzeichnet, dass** die Prüfeinrichtung (2) einen Spiegel (41) zur Bildumlenkung für die optische Erfassungseinrichtung (34) aufweist.

5. Prüfeinrichtung nach einem der vorhergehenden Ansprüche, **dadurch gekennzeichnet, dass** die Prüfeinrichtung (2) ein abdunkelbares Gehäuse (16) mit einem Prüfbereich (19) im Innenraum aufweist.

6. Prüfeinrichtung nach einem der vorhergehenden Ansprüche, **dadurch gekennzeichnet, dass** die Stützeinrichtung (24) als ortsveränderlicher Förderer (28) ausgebildet ist und eine Entlastungseinrichtung (31) zu Verminderung der Reibung zwischen Solarmodul (3) und Förderer (28) aufweist.

7. Prüfeinrichtung nach einem der vorhergehenden Ansprüche, **dadurch gekennzeichnet, dass** die Prüfeinrichtung (2) eine Zuführ- und Abführeinrichtung (13,14) und lichtdicht verschließbare Ein- und Auslässe (17,18) für das Solarmodul (3) aufweist.

8. Fertigungseinrichtung für mehrlagige Solarmodule (3) mit einer Solarzellenanordnung (4), **dadurch gekennzeichnet, dass** die Fertigungseinrichtung (1) eine Prüfeinrichtung (2) gemäß einem der Ansprüche 1 bis 7 aufweist.

9. Fertigungseinrichtung nach Anspruch 8, **dadurch gekennzeichnet, dass** die Fertigungseinrichtung (1) eine Assemblingeinrichtung (52) für die Bildung von Solarmodulen (3) mit mehreren losen Lagen (5,6,7,8) und eine endseitige Fixiereinrichtung (55), insbesondere einen Laminator, für die Solarmodule (3) aufweist.

10. Fertigungseinrichtung nach Anspruch 8 oder 9, **dadurch gekennzeichnet, dass** die Fertigungseinrichtung (1) einen Stringer (51) und eine mehrachsige Handhabungseinrichtung (49) für Solarzellenstrings aufweist.

11. Verfahren zum Prüfen eines mehrlagigen Solarmoduls (3) mit einer Solarzellenanordnung (4), wobei das Solarmodul (3) an einem inneren Bereich (10) seiner Unterseite (9) von einer dort angreifenden beweglichen Stützeinrichtung (24) gestützt wird, die wechselnde Bereiche (27) der Unterseite (9) beidseits der Mitte (23) abdeckt, wobei von einer auf die Unterseite (9) blickenden optischen Erfassungseinrichtung (34) ein Prüfbild (40) der Unterseite (9) erzeugt wird, an dem der von der Stützeinrichtung (24) abgedeckte Bereich (24) sichtbar gemacht wird.

12. Verfahren nach Anspruch 11, **dadurch gekennzeichnet, dass** mit der optischen Erfassungseinrichtung (34) Teilbilder (38,39) und daraus ein zusammengesetztes Prüfbild (40) erzeugt werden, in welchem die von der Stützeinrichtung (24) abgedeckten Bereiche (27) sichtbar gemacht werden.

13. Verfahren nach Anspruch 11 oder 12, **dadurch gekennzeichnet, dass** eine optische Erfassungseinrichtung (34) Teilbilder (38,39) von beidseits der Mitte (23) gelegenen und nicht abgedeckten Bereichen der Unterseite (9) erzeugt und die Teilbilder (38,39) zusammensetzt.

14. Verfahren nach einem der Ansprüche 11 bis 13, **dadurch gekennzeichnet, dass** bei einer optischen Werkstückprüfung eine Durchlichtprüfung des Solarmoduls (3) mit einem geeigneten und ggf. für das menschliche Auge unsichtbaren Licht, insbesondere mit Infrarotlicht, durchgeführt wird und/oder bei einer optischen Werkstückprüfung eine Luminiszenzprüfung des Solarmoduls (3) durchgeführt wird, wobei Solarzellen zum Selbstleuchten angeregt werden.

15. Verfahren nach einem der Ansprüche 11 bis 14, **dadurch gekennzeichnet, dass** Solarmodule in (3) Sandwichform mit mehreren losen Lagen (5,6,7,8) gebildet und geprüft sowie nach der Prüfung fixiert, insbesondere laminiert werden.

## Claims

1. Test device for a multilayer solar module (3) having a solar cell assembly (4), wherein the test device (2) has a support (20) at the edge for the solar module (3) and a supporting device (24) acting on an inner region (10) of the underside (9) of the solar module (3), and an optical detection device (34) looking at the underside (9), which device generates a test image (40) of the underside (9) which contains the solar cell assembly (4) and on which the region (24) covered by the supporting device (24) has been revealed, wherein the supporting device (24) is movable and covers alternating regions (27) of the underside (9).

2. Test device according to Claim 1, **characterized in that** an offsetting device (30) is provided for changing the position of the supporting device (24).

3. Test device according to Claim 1 or 2, **characterized in that** the optical detection device (34) generates partial images (38, 39) including supporting device (24) and places the same one above another in a test image (40), the supporting device (24) being masked out and the covered regions (27) being revealed.

4. Test device according to Claim 1, 2 or 3, **characterized in that** the test device (2) has a mirror (41) for image deflection for the optical detection device (34).

5. Test device according to one of the preceding claims, **characterized in that** the test device (2) has a housing (16) that can be darkened, with a test region (19) in the interior.

6. Test device according to one of the preceding claims, **characterized in that** the supporting device (24) is constructed as a variable-location conveyor (28), and has a load-relieving device (31) for reducing the friction between solar module (3) and conveyor (28).

7. Test device according to one of the preceding claims, **characterized in that** the test device (2) has a supply and discharge device (13, 14) and inlets and outlets (17, 18) that can be closed in a light-tight manner for the solar module (3).

8. Manufacturing device for multilayer solar modules (3) having a solar cell assembly (4), **characterized in that** the manufacturing device (1) has a test device (2) according to one of Claims 1 to 7.

9. Manufacturing device according to Claim 8, **characterized in that** the manufacturing device (1) has an assembling device (52) for the formation of solar modules (3) with a plurality of loose layers (5, 6, 7, 8) and a fixing device (55) at the end, in particular a laminator, for the solar modules (3).

10. Manufacturing device according to Claim 8 or 9, **characterized in that** the manufacturing device (1) has a stringer (51) and a multi-axis handling device (49) for solar cell strings.

11. Method for testing a multilayer solar module (3) having a solar cell assembly (4), wherein the solar module (3) is supported in an inner region (10) of its underside (9) by a movable supporting device (24) acting there, which covers alternating regions (27) of the underside (9) on both sides of the centre (23), wherein a test image (40) of the underside (9) is generated by an optical detection device (34) looking at the underside (9), on which image the region (24) covered by the supporting device (24) is revealed.

12. Method according to Claim 11, **characterized in that** partial images (38, 39) are generated by the optical detection device (34) and, from these, a combined test image (40) is generated, in which the regions (27) covered by the supporting device (24) are revealed.

13. Method according to Claim 11 or 12, **characterized in that** an optical detection device (34) generates partial images (38, 39) of regions of the underside (9) placed on both sides of the centre (23) and not covered and combines the partial images (38, 39).

14. Method according to one of Claims 11 to 13, **characterized in that** during an optical workpiece test a transmitted-light test of the solar module (3) is carried out with light that is suitable and possibly invisible to the human eye, in particular with infrared light, and/or during an optical workpiece test, a luminescence test of the solar module (3) is carried out, wherein solar cells are excited to self-illuminate.

15. Method according to one of Claims 11 to 14, **characterized in that** solar modules (3) are formed and tested in sandwich form with multiple loose layers (5, 6, 7, 8), and are fixed following the test, in particular laminated.

## Revendications

1. Dispositif de test destiné à un module solaire multicouche (3) comportant un système de cellules solaires (4), dans lequel le dispositif de test (2) comporte un support périphérique (20) destiné au module solaire (3) ainsi qu'un dispositif de support (24) s'engageant sur une région intérieure (10) de la face inférieure (9) du module solaire (3) et un dispositif de détection optique (34) pointant vers la face inférieure (9), qui génère une image de test (40) de la face inférieure (9) contenant le système de cellules solaires (4), image sur laquelle la région recouverte (24) par le dispositif de support (24) est rendue visible, dans lequel le dispositif de support (24) est mobile et recouvre des régions variables (27) de la face inférieure (9).

2. Dispositif de test selon la revendication 1, **caractérisé en ce qu'**il est prévu un dispositif de décalage (30) pour modifier la position du dispositif de support (24).

3. Dispositif de test selon la revendication 1 ou 2, **caractérisé en ce que** le dispositif de détection optique (34) génère des images partielles (38,39), en incluant le dispositif de support (24), et les superpose les unes aux autres pour obtenir une image de test (40), dans lequel le dispositif de support (24) est masqué et les régions recouvertes (27) sont rendues visibles.

4. Dispositif de test selon la revendication 1, 2 ou 3, **caractérisé en ce que** le dispositif de test (2) comporte un miroir (41) de renvoi d'image destiné au dispositif de détection optique (34).

5. Dispositif de test selon l'une quelconque des revendications précédentes, **caractérisé en ce que** le dispositif de test (2) comporte dans l'espace intérieur un boîtier occultable (16) ayant une région de test (19).

6. Dispositif de test selon l'une quelconque des revendications précédentes, **caractérisé en ce que** le dispositif de support (24) est réalisé sous la forme d'un transporteur mobile (28) et comporte un dispositif de réduction de la charge (31) destiné à diminuer le frottement entre le module solaire (3) et le transporteur (28).

7. Dispositif de test selon l'une quelconque des revendications précédentes, **caractérisé en ce que** le dispositif de test (2) comporte un dispositif d'amenée et d'évacuation (13,14) et des entrées et des sorties (17,18) pouvant être fermées de manière opaque à la lumière pour le module solaire (3).

8. Dispositif de fabrication destiné à des modules solaires multicouches (3) comportant un système de cellules solaires (4), **caractérisé en ce que** le dispositif de fabrication (1) comporte un dispositif de test (2) selon l'une quelconque des revendications 1 à 7.

9. Dispositif de fabrication selon la revendication 8, **caractérisé en ce que** le dispositif de fabrication (1) comporte un dispositif d'assemblage (52) destiné à la réalisation de modules solaires (3) ayant plusieurs positions non fixes (5,6,7,8) et un dispositif de fixation côté extrémité (55), notamment un dispositif de stratification, destinés aux modules solaires (3).

10. Dispositif de fabrication selon la revendication 8 ou 9, **caractérisé en ce que** le dispositif de fabrication (1) comporte un dispositif de formation de chaînes (51) et un dispositif de maniement à plusieurs axes (49) destiné à des chaînes de cellules solaires.

11. Procédé pour tester un module solaire multicouche (3) comportant un système de cellules solaires (4), dans lequel le module solaire (3) est supporté sur une région intérieure (10) de sa face inférieure (9) par un dispositif de support mobile (24) s'engageant à cet endroit, qui recouvre des régions variables (27) de la face inférieure (9) de part et d'autre du milieu (23), dans lequel une image de test (40) de la face inférieure (9) est générée par un dispositif de détection optique (34) pointant vers la face inférieure (9), sur lequel la région recouverte (24) par le dispositif de support (24) est rendue visible.

12. Procédé selon la revendication 11, **caractérisé en ce qu'**on génère au moyen du dispositif de détection optique (34) des images partielles (38,39) et, à partir de celles-ci, une image de test composite (40) dans laquelle les régions (27) recouvertes par le dispositif de support (24) sont rendues visibles.

13. Procédé selon la revendication 11 ou 12, **caractérisé en ce qu'**un dispositif de détection optique (34) génère des images partielles (38,39) de régions de la face inférieure (9) situées de part et d'autre du milieu (23) et non recouvertes et combine les images partielles (38,39).

14. Procédé selon l'une quelconque des revendications 11 à 13, **caractérisé en ce que**, lors d'un test optique de pièces à usiner, un test de transparence à la lumière du module solaire (3) est effectué au moyen d'une lumière appropriée et, le cas échéant, invisible à l'humain oeil, notamment au moyen d'une lumière infrarouge, et/ou **en ce que**, lors d'un test optique de pièces à usiner, un test de luminescence du module solaire (3) est effectué, dans lequel des cellules solaires sont excitées jusqu'à luminescence.

15. Procédé selon l'une quelconque des revendications 11 à 14, **caractérisé en ce que** des modules solaires (3) sont réalisés sous forme de sandwich ayant plusieurs positions non fixes (5,6,7,8) et sont testés et fixés, notamment stratifiés, après le test.
